# EUROPEAN PATENT SPECIFICATION

(11) **EP 0 545 905 B1**
(45) Date of publication and mention of the grant of the patent: **29.01.1997**
(21) Application number: 93102503.5
(22) Date of filing: 25.07.1988
(51) Int. Cl.: H01S 3/025, G02B 6/42, G11B 7/135

(54) **Optical pickup element**
Optischer Wandler
Elément de tête optique

(30) Priority: 30.07.1987 JP 190788/87
(43) Date of publication of application: 09.06.1993
(62) Divisional of application: 88306833.0
(73) Proprietor: SONY CORPORATION, Tokyo (JP)
(72) Inventor: Yoshitoshi, You, Ashiya-shi, Hyogo-ken (JP); Matsumoto, Yoshiyuki, Shinagawa-ku, Tokyo (JP); Kume, Hidehiro, Shinagawa-ku, Tokyo (JP); Mitsumori, Koji, Shinagawa-ku, Tokyo (JP); Yamamoto, Etsufumi, Shinagawa-ku, Tokyo (JP); Oinoue, Hiroshi, Shinagawa-ku, Tokyo (JP)
(74) Representative: Ayers, Martyn Lewis Stanley

(56) References cited:
- EP-A- 0 199 565
- DE-A- 3 627 441
- JP-A-62 196 880
- PATENT ABSTRACTS OF JAPAN vol. 10, no. 157 (P-464) 6 June 1986 & JP-A-61 009 845
- PATENT ABSTRACTS OF JAPAN vol. 10, no. 274 (P-498) 18 September 1986 & JP-A-61 096 534
- PATENT ABSTRACTS OF JAPAN vol. 7, no. 94 (E-171)(1239) 20 April 1983 JP-A-58 016 584

## Description

The present invention relates generally to optical pickup devices and more particularly to an optical pickup device in which a light emitting element and a light receiving element are formed integrally on a semi-conductor substrate.

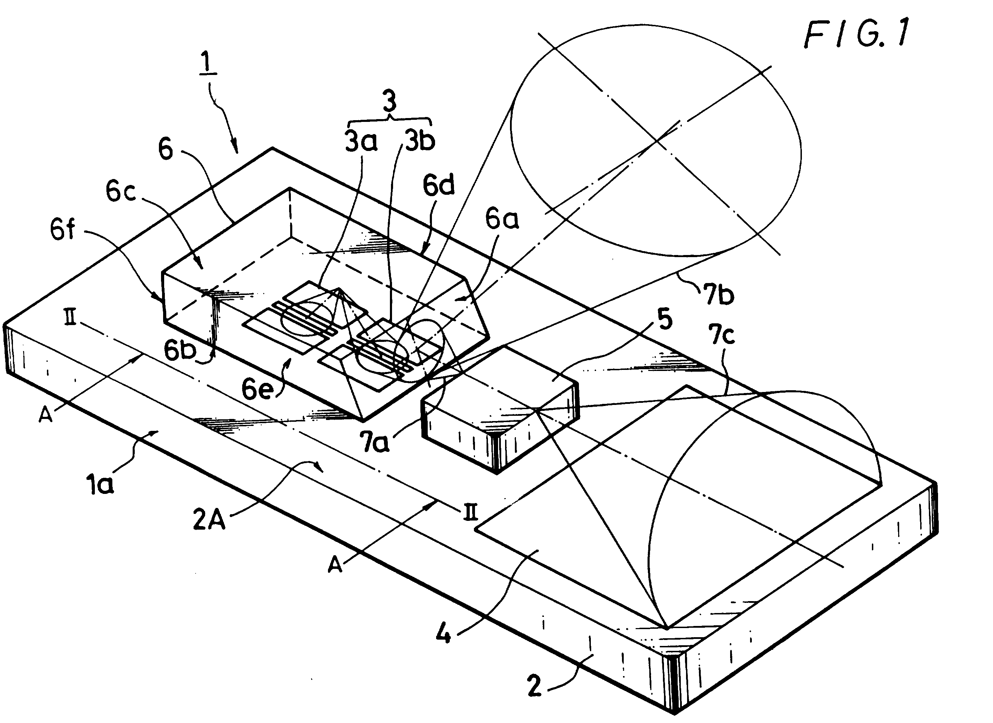

Optical heads with various structures have been proposed so far to detect information from information pits formed on the surface of a substrate, as in a compact disc (CD) or the like. Figure 1 illustrates in perspective a structure of an optical pickup device employing a composite light emitting and/or light receiving element that we have proposed in Japanese Patent Publication No 62-196880 (published on 31 August 1987).

As Figure 1 shows, there is provided an optical head 1 in which a first photodetector 3 constituted by a so-called PIN diode or the like is formed, for example, on the left-hand side half of a major surface 2A of a rectangular semi-conductor substrate 2 made of silicon or the like to act as a light receiving element. The first photodetector 3 is formed of, for example, two sets of photodetectors 3a and 3b, each of which is divided to provide three photodetecting portions. A second photodetector 4 constituted by a PIN diode or the like for monitoring is formed on the right-hand side half of the major surface 2A of the semi-conductor substrate 2 as a light receiving element, if necessary. Between the first and second photodetectors 3 and 4, a light emitting element 5 such as a semiconductor laser chip or the like is directly soldered to the major surface 2A of the semi-conductor substrate 2. Also, there is provided an optical path branching part, i.e. a prism 6. This prism 6 is trapezoidal in cross-section and is mounted on the major surface 2A of the semi-conductor substrate 2 to cover the first photodetector 3, thus forming a composite light emitting/light receiving element la. The prism 6 has an inclined face 6a opposing the light emitting point of the active layer in the semi-conductor laser chip 5. This face 6a is formed as a semi-transparent reflection face. Meanwhile, in a face 6b of the prism 6 contacting with the semi-conductor substrate 2, the area other than that contacting the photodetectors 3a and 3b and a face 6c of the prism 6 opposing the face 6b are each formed as a reflection face.

With the abovementioned arrangement, a laser beam 7a emitted from the active layer of the semiconductor laser chip 5 is reflected on the semi-transparent reflection face 6a of the prism 6 and is then irradiated onto an optical disc through an objective lens (not shown) as an incident laser beam 7b. The light of the incident laser beam 7b reflected from the optical disc travels through the face 6a of the prism 6 and is incident on the first set of photodetectors 3a. The light passed through the face 6a is reflected by a semi-transparent layer (not shown) formed between the prism 6 and the first set of photodetectors 3a and is then reflected on the face 6c of the prism 6 to become incident on the second set of photodetectors 3b, whereby the data corresponding to the information pits on the optical disc are detected. A laser beam 7c is emitted from an opposite active layer of the semiconductor laser chip 5 for monitoring.

In the abovementioned composite light emitting/light receiving element 1a, a part of the laser beam, which is emitted from the semi-conductor laser chip 5, travels through the prism 6 and directly becomes incident on the first photodetector 3 and this undesired, stray, light constitutes noise added to the detecting signal.

From experimental results, it was noted that while the undesired light incident on the prism can be removed in the conventional composite light emitting/light receiving element 1a, another kind of undesired light is produced which exerts a bad influence upon the detecting signal that the first photo detector 3 produces.

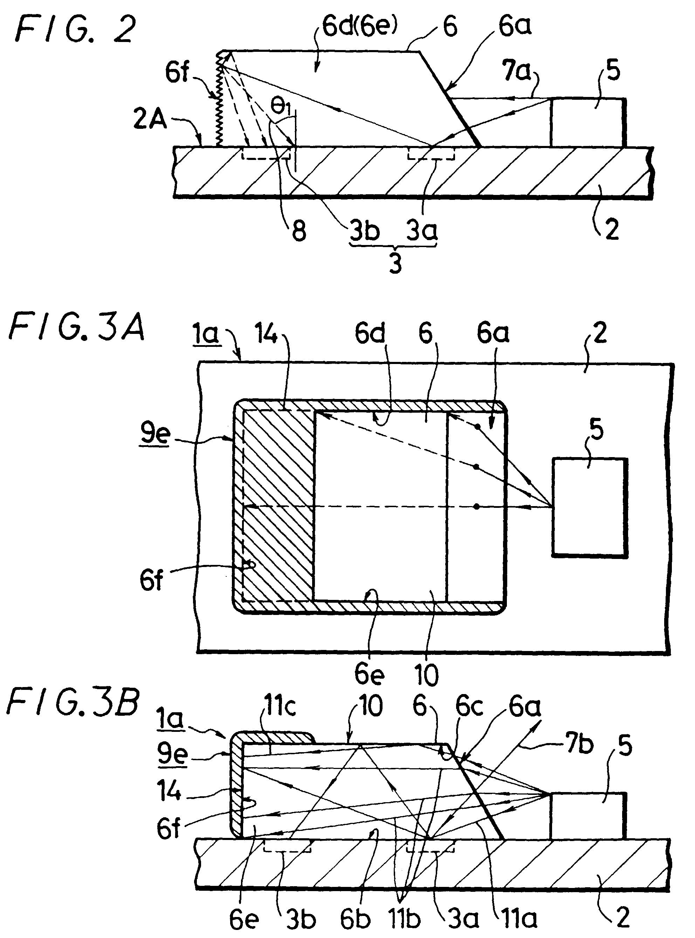

Referring to fig 2, let us now explain why such other kind of undesired light is produced. Fig. 2 is a fragmentary cross-sectional side view taken through the line II-II of Fig. 1, looking in the direction indicated by the arrow A. Except for the semi-transparent reflection face 6a of the prism 6 formed on the major surface 2A of the semi-conductor substrate 2 to cover the first photo detector 3, left, right and rear side wall faces 6d, 6e and 6f are formed as faces that are not calendered. For example, they are formed as smoked-glass faces. For this reason, a part of the laser beam 7a emitted from the active layer of the semi-conductor laser chip 5 travels through the semi-transparent reflection face 6a and is then reflected and/or scattered on the side wall faces 6d, 6e and 6f in the prism 6. Thus, as shown by reflected and/or scattered laser beams 8 represented as broken lines in Fig. 2, undesired light again becomes incident on the light receiving faces of the photo detectors 3a and 3b with a smaller incident angle θ1. Such an undesired light is superimposed upon an RF signal from the first photo detector 3 as a DC offset signal, thereby to exert a bad influence on the detecting signal. Another reason that there exists much undesired light beams which are repeatedly reflected and/or scattered within the prism 6 is that the refractive index of the material forming the prism 6 is larger than the refractive index of air and hence the undesired light beams are not radiated from the prism 6 to the air.

EP-A-0 199 565 discloses an optical pickup device in which a first substrate carried a triangular optical path branching optical element and a laser element mounted on a second substrate mounted on said first substrate directs light onto an inclined semi-transparent front surface of the optical element. Light is reflected off the front surface of the optical element to a recording medium. Returning light passes through the front surface to a photodetector formed in the substrate below the optical element.

It is an aim of the present invention and the preferred embodiments to provide an improved optical pickup device which can produce a stable detecting signal from a photodetector thereof and can be manufactured at low cost.

The present invention is defined in claim 1.

An embodiment of the present invention will now be described, by way of example only, with reference to the accompanying drawings, in which:-
Figure 1 is a perspective view of an example of optical pickup device not in accordance with the present invention;
Figure 2 is a cross-sectional side view taken through the line II-II in Figure 1, looking in the direction represented by arrow A;
Fig 3A is a plan view illustrating an embodiment of optical pickup device according to the present invention; and
Fig. 3B is a fragmentary cross-sectional side view of the device of Fig. 3A.

Fig 3A illustrates in plan view an embodiment of optical pickup device in accordance with the present invention and employing a composite light emitting/light receiving element.

In Figs. 3A and 3B, like parts corresponding to those of Figs. 1 and 2 are marked with the same references and therefore need not be described in detail.

In Figs. 3A and 3B, the shape of the rear side wall face 6f of the prism 6 is not modified at all as compared with that shown in Figs. 1 and 2 but a light absorption material 14 is coated on the left and right side wall faces 6d and 6e and the rear side wall face 6f of the prism 6. The kind of light absorption material 14 is selected in accordance with the wavelength of the laser beam emitted from the semi-conductor laser chip 5. For example, a black paint or the like is coated on the left and right side wall faces 6d and 6e and the rear side wall face 6f with a predetermined coating pattern. Since an area 10 of the upper face 6c of the prism 6 is necessary for reflecting the signal detecting light which results from reflecting the laser beam 7b on the optical disc so as to become incident on the photo detector element 3b, the light absorption material 14 is not coated on the area 10 of the upper face 6c of the prism 6 which reflects such light beam as mentioned above. The light absorption material 14 may be coated on the rear area of the upper face 6c of the prism 6 as illustrated in Fig. 3A.

Further, the light absorption material 14 may be of a material that has the same refractive index as that of the prism 6. If the kind of the light absorption material 14 is selected as described above, the reflection on the interface between the prism 6 and the light absorption material 14 can be removed.

According to the above mentioned arrangement, almost all of the incident laser beams propagating along the optical paths 11a to 11c within the prism 6, which will become the undesired light beams, can be absorbed by the light absorption material 14, thus forming the undesired light preventing means 9e.

By coating light absorption material on the rear face of the prism of the illustrated embodiment of the invention, undesired light within the prism can be substantially avoided, removing the need to separate electronically the detecting signal and undesired light. Thus, without such a separation circuit, the optical pickup can substantially avoid the problem of undesired light and produce a stable detecting signal from its photo detecting means. Also, the optical pickup device of the present invention can be manufactured at low cost.

## Claims

1. An optical pickup device comprising:
(a) a substrate (2);
(b) a semi-conductor laser element (5) mounted on said substrate (2);
(c) a photodetector (3) for receiving a laser beam emitted from said semi-conductor laser element (5) formed on said substrate (2), the semi-conductor laser element (5) being mounted directly on the surface of the substrate (2) on which the photodetector (3) is formed; and
(d) an optical path branching optical element (6) fixed to said substrate (2) over said photodetector (3), said optical element (6) being trapezoidal in cross-section and including an upper face (6c), an inclined semi-transparent front face (6a) positioned opposite said laser element (5) and a rear face (6f) positioned opposite said front face;
whereby part of the light emitted from said laser element (5) is reflected off said front face (6a) and part of said light incident on said front face (6a) to directed to said photodetector (3);
characterised in that the semi-transparency of the front face (6a) is provided by a semi-transparent reflection film deposited thereon; and said rear face (6f) and the rear area of the upper face (6c), said rear area being adjacent to said rear face (6f), is coated with light absorption material (14) to substantially absorb light incident thereon to substantially prevent said incident light from being reflected into said photodetector (3), said light absorption material (14) being chosen to absorb light of the wavelength(s) emitted from said semi-conductor laser element.

2. A device as claimed in claim 1, wherein the optical path branching optical element (6) has left and right side faces (6d,6e), said side faces also being coated with light absorption material (14).

3. A device as claimed in any of the preceding claims, wherein the light absorption material (14) is applied to the optical path branching optical element (6) in a predetermined coating pattern.

4. A device as claimed in any of the preceding claims, wherein the light absorption material (14) is black paint or the like.

5. A device as claimed in any of the preceding claims, wherein the light absorption material (14) has the same refractive index as the optical path branching optical element.

## Patentansprüche

1. Optische Wandlervorrichtung, welche umfaßt:
(a) ein Substrat (2);
(b) ein Halbleiter-Laserelement (5), welches auf dem Substrat (2) angebracht ist;
(c) einen Fotodetektor (3) zum Empfang eines von dem auf dem Substrat (2) ausgebildeten Halbleiter-Laserelement (5) ausgesendeten Laserstrahls, wobei das Halbleiter-Laserelement (5) direkt auf der Oberfläche des Substrats (2), auf dem der Fotodetektor (3) ausgebildet ist, angebracht ist; und
(d) ein den optischen Pfad verzweigendes optisches Element (6), das über dem Fotodetektor (3) auf dem Substrat (2) befestigt ist, wobei das optische Element (6) einen trapezförmigen Querschnitt aufweist und eine obere Fläche (6c), eine geneigte halbdurchlässige vordere Fläche (6a), welche gegenüber dem Laserelement (5) angeordnet ist, und eine rückseitige Fläche (6f), welche gegenüber der vorderen Fläche angeordnet ist, umfaßt;
wobei ein Teil des von dem Laserelement (5) ausgesendeten Lichts von der vorderen Fläche (6a) fort reflektiert wird und ein Teil des Lichts, das auf die vordere Fläche (6a) trifft, auf den Fotodetektor (3) gerichtet wird;
dadurch gekennzeichnet,
daß die Halbdurchlässigkeit der vorderen Fläche (6a) durch eine halbdurchlässige Reflexionsschicht, welche darauf aufgebracht ist, erreicht wird; und daß die rückseitige Fläche (6f) und der hintere Bereich der oberen Fläche (6c), wobei der hintere Bereich an die rückseitige Fläche (6f) angrenzt, mit einem lichtabsorbierenden Material (14) beschichtet sind, um darauf auftreffendes Licht im wesentlichen zu absorbieren, um im wesentlichen zu verhindern, daß auftreffendes Licht in den Fotodetektor (3) reflektiert wird, wobei das lichtabsorbierende Material (14) ausgewählt ist, um Licht der Wellenlänge(n) zu absorbieren, welches von dem Halbleiter-Laserelement ausgesendet wird.

2. Vorrichtung nach Anspruch 1, bei welcher das den optischen Pfad verzweigende optische Element (6) linke und rechte seitliche Flächen (6d, 6e) besitzt, wobei diese seitlichen Flächen ebenfalls mit lichtabsorbierendem Marerial (14) beschichtet sind.

3. Vorrichtung nach einem der vorhergehenden Ansprüche, bei welcher das lichtabsorbierende Material (14) auf das den optischen Pfad verzweigende optische Element (6) in einem vorgegebenen Beschichtungsmuster aufgetragen ist.

4. Vorrichtung nach einem der vorhergehenden Ansprüche, bei welcher das lichtabsorbierende Material (14) eine schwarze Farbe oder dergleichen ist.

5. Vorrichtung nach einem der vorhergehenden Ansprüche, bei welcher das lichtabsorbierende Material (14) den gleichen Brechungsindex wie das den optischen Pfad verzweigende optische Element aufweist.

## Revendications

1. Dispositif capteur optique comprenant :
(a) un substrat (2);
(b) un élément laser à semiconducteur (5) monté sur ledit substrat (2) ;
(c) un photodétecteur (3) servant à recevoir un faisceau laser émis par ledit élément laser à semiconducteur (5) qui est formé sur ledit substrat (2), l'élément laser à semiconducteur (5) étant monté directement sur la surface du substrat (2) sur laquelle est formé le photodétecteur (3) ; et
(d) un élément optique de dérivation de trajet optique (6) fixé audit substrat (2) sur ledit photodétecteur (3), ledit élément optique (6) ayant une section droite en forme de trapèze et comportant une face supérieure (6c), une face avant semitransparente inclinée (6a) qui est placée en regard dudit élément laser (5) et une face arrière (6f) placée en regard de ladite face avant ;
si bien qu'une partie de la lumière émise depuis ledit élément laser (5) est réfléchie par ladite face avant (6a) et une partie de ladite lumière arrivant ensuite sur ladite face avant (6a) est dirigée sur ledit photodétecteur (3) ;
caractérisé en ce que la propriété semitransparente de la face avant (6a) est produite par une pellicule de réflexion semitransparente qui y est déposée, et ladite face arrière (6f) et l'aire postérieure de la face supérieure (6c) sont revêtues d'un matériau d'absorption de lumière (14) de façon que la lumière qui arrive sur elles soit sensiblement absorbée afin d'empêcher sensiblement ladite lumière incidente d'être réfléchie dans ledit photodétecteur (3), ledit matériau d'absorption de lumière (14) étant choisi de façon à absorber la lumière de la ou des longueurs d'onde qui est émise par ledit élément laser à semiconducteur.

2. Dispositif selon la revendication 1, où l'élément optique de dérivation de trajet optique (6) possède des faces latérales gauche et droite (6d, 6e), lesdites faces latérales étant revêtues par le matériau d'absorption de lumière (14).

3. Dispositif selon l'une quelconque des revendications précédentes, où le matériau d'absorption de lumière (14) est appliqué à l'élément optique de dérivation de trajet optique (6) suivant un motif de revêtement prédéterminé.

4. Dispositif selon l'une quelconque des revendications précédentes, où le matériau d'absorption de lumière (14) est une peinture noire, ou un moyen analogue.

5. Dispositif selon l'une quelconque des revendications précédentes, où le matériau d'absorption de lumière (14) possède le même indice de réfraction que l'élément optique de dérivation de trajet optique.
